# EUROPEAN PATENT APPLICATION

(11) **EP 4 672 900 A1**
(43) Date of publication of application: **31.12.2025**
(21) Application number: 25181415.8
(22) Date of filing: 06.06.2025
(51) Int. Cl.: H10D 30/01, H10D 30/47, H10D 64/00, H10D 64/23

(54) **TRANSISTOR DEVICE WITH METAL BACKSIDE FIELD PLATE**

(30) Priority: 25.06.2024 US 202418753656
(71) Applicant: Analog Devices, Inc., Wilmington, MA 01887 (US)
(72) Inventor: FIORENZA, James G., Wilmington, MA 01887 (US); PIEDRA, Daniel, Wilmington, MA 01887 (US)
(74) Representative: Yang, Shu

(57) **Abstract**

Using various techniques, a metal backside field plate is formed at the end of the process. In an example, the GaN layer is grown, the HEMT is fabricated, and the substrate is thinned. A via is made through the thinned substrate and GaN epi to the underside of the source electrode and the metal backside field plate is then deposited. In another example, a pocket for the backside field plate is formed completely through the thickness of the substrate, a via is formed through the GaN to the source electrode, and then the metal backside field plate is deposited in the pocket.

## Description

This patent application claims the benefit of priority of US non-provisional application US 18/753,656 entitled "TRANSISTOR DEVICE WITH METAL BACKSIDE FIELD PLATE," filed on June 25, 2024.

### FIELD OF THE DISCLOSURE

This document pertains generally, but not by way of limitation, to semiconductor devices, and more particularly, to techniques for constructing gallium nitride devices.

### BACKGROUND

Gallium nitride (GaN) based semiconductors offer several advantages over other semiconductors as the material of choice for fabricating the next generation of transistors, or semiconductor devices, for use in both high-voltage and high-frequency applications. GaN-based semiconductors, for example, have a wide bandgap that enables devices fabricated from these materials to have a high breakdown electric field and to be robust to a wide range of temperatures. The two-dimensional electron gas (2DEG) channels formed by GaN-based heterostructures generally have high electron mobility, making devices fabricated using these structures useful in power-switching and amplification systems.

### SUMMARY OF THE DISCLOSURE

Using various techniques of this disclosure, a metal backside field plate is formed at the end of the process. In an example, the GaN layer is grown, the HEMT is fabricated, and the substrate is thinned. A via is made through the thinned substrate and GaN epi to the underside of the source electrode and the metal backside field plate is then deposited. In another example, a pocket for the backside field plate is formed completely through the thickness of the substrate, a via is formed through the GaN to the source electrode, and then the metal backside field plate is deposited in the pocket.

In some aspects, this disclosure is directed to a method of forming a compound semiconductor heterostructure transistor device, the method comprising: forming a first semiconductor material layer over a substrate; forming a second semiconductor material layer over the first semiconductor material layer to form a compound semiconductor heterostructure having a two-dimensional electron gas (2DEG) channel, wherein the 2DEG channel is more conductive than either the first semiconductor material layer or the second semiconductor material layer; electrically coupling a drain electrode and a source electrode with the 2DEG channel; forming a gate electrode over the second semiconductor material layer; thinning the substrate to a predetermined thickness; forming a via to the source electrode; depositing a first metal into the via; and forming, using a second metal, a backside field plate (BFP) beneath the thinned substrate, wherein the BFP is coupled with the first metal and extends laterally from a first region adjacent to the via to a second region between the gate electrode and the drain electrode.

In some aspects, this disclosure is directed to a method of forming a compound semiconductor heterostructure transistor device, the method comprising: forming a first semiconductor material layer over a substrate; forming a second semiconductor material layer over the first semiconductor material layer to form a compound semiconductor heterostructure having a two-dimensional electron gas (2DEG) channel, wherein the 2DEG channel is more conductive than either the first semiconductor material layer or the second semiconductor material layer; electrically coupling a drain electrode and a source electrode with the 2DEG channel; forming a gate electrode over the second semiconductor material layer; removing at least a portion of the substrate to form a cavity, wherein the cavity extends laterally from a first region at least partially underlying the source electrode to a second region between the gate electrode and the drain electrode; forming a via through the first semiconductor material layer and the second semiconductor material layer to the source electrode; depositing a first metal into the via; and forming, using a second metal, a backside field plate (BFP) within the cavity, wherein the BFP is coupled with the first metal and extends laterally from the first region to the second region.

In some aspects, this disclosure is directed to a compound semiconductor heterostructure transistor device comprising: a substrate; a first semiconductor material layer formed over the substrate; a second semiconductor material layer formed over the first semiconductor material layer to form a compound semiconductor heterostructure having a two-dimensional electron gas (2DEG) channel, wherein the 2DEG channel is more conductive than either the first semiconductor material layer or the second semiconductor material layer; a drain electrode electrically coupled with the 2DEG channel; a source electrode electrically coupled with the 2DEG channel; a gate electrode formed over the second semiconductor material layer; and a metal backside field plate formed within a cavity of the substrate, wherein the backside field plate extends laterally from a first region at least partially underlying the source electrode to a second region between the gate electrode and the drain electrode, wherein the backside field plate is electrically coupled to the source electrode.

### BRIEF DESCRIPTION OF THE DRAWINGS

In the drawings, which are not necessarily drawn to scale, like numerals may describe similar components in different views. Similar components in different views may be described by like numerals. The drawings illustrate generally, by way of example, but not by way of limitation, various embodiments discussed in the present document.
FIG. 1A - FIG. 1D depict an example of a simplified process flow for forming a compound semiconductor heterostructure transistor device, in accordance with this disclosure.
FIG. 2 is a flow diagram depicting an example of a method of forming a compound semiconductor heterostructure transistor device.
FIG. 3A - FIG. 3D depict another example of a simplified process flow for forming a compound semiconductor heterostructure transistor device, in accordance with this disclosure.
FIG. 4 is a flow diagram depicting another example of a method of forming a compound semiconductor heterostructure transistor device.

### DETAILED DESCRIPTION

As used in this disclosure, a GaN-based compound semiconductor material may include a chemical compound of elements including GaN and one or more elements from different groups in the periodic table. Such chemical compounds may include a pairing of elements from group 13 (i.e., the group comprising boron (B), aluminum (Al), gallium (Ga), indium (In), and thallium (Tl)) with elements from group 15 (i.e., the group comprising nitrogen (N), phosphorus (P), arsenic (As), antimony (Sb), and bismuth (Bi)). Group 13 of the periodic table may also be referred to as Group III and group 15 as Group V. In an example, a semiconductor device may be fabricated from GaN and aluminum indium gallium nitride (AlInGaN).

Heterostructures described herein may be formed as AlN / GaN / AlN hetero-structures, InAlN / GaN heterostructures, AlGaN/GaN heterostructures, or heterostructures formed from other combinations of group 13 and group 15 elements. These heterostructures may form a two-dimensional electron gas (2DEG) at the interface of the compound semiconductors that form the heterostructure, such as the interface of GaN and AlGaN. The 2DEG may form a conductive channel of electrons that may be controllably depleted, such as by an electric field formed by a buried layer of p-type material disposed below the channel. The conductive channel of electrons may also be controllably enhanced, such as by an electric field formed by a gate terminal disposed above the channel to control a current through the semiconductor device. Semiconductor devices formed using such conductive channels may include high electron mobility transistor (HEMT) devices.

Conventional GaN devices rely on topside field plates to manage the electric field in the drain access region. However, by using a backside field plate, the designer is given an additional layer of control for the electric field. Additionally, backside field-plated devices may forgo the topside field plate and its support dielectric, thereby allowing such devices to operate at higher frequencies, no longer hindered by the parasitic gate capacitance.

Backside field plates may be formed by doping or growth, such as by growing p-GaN or aluminum nitride structures in the GaN. The present inventors have recognized the desirability of explicitly using a metal as a backside field plate. They also recognized the difficulty in performing a high-temperature epitaxial growth used to form the HEMT device when the metal for the backside field plate is exposed on a substrate.

Using various techniques of this disclosure, a metal backside field plate is formed at the end of the process. In an example, the GaN layer is grown, the HEMT is fabricated, and the substrate is thinned. A via is made through the thinned substrate and GaN epi to the underside of the source electrode and the metal backside field plate is then deposited. In another example, a pocket for the backside field plate is formed completely through the thickness of the substrate, a via is formed through the GaN to the source electrode, and then the metal backside field plate is deposited in the pocket.

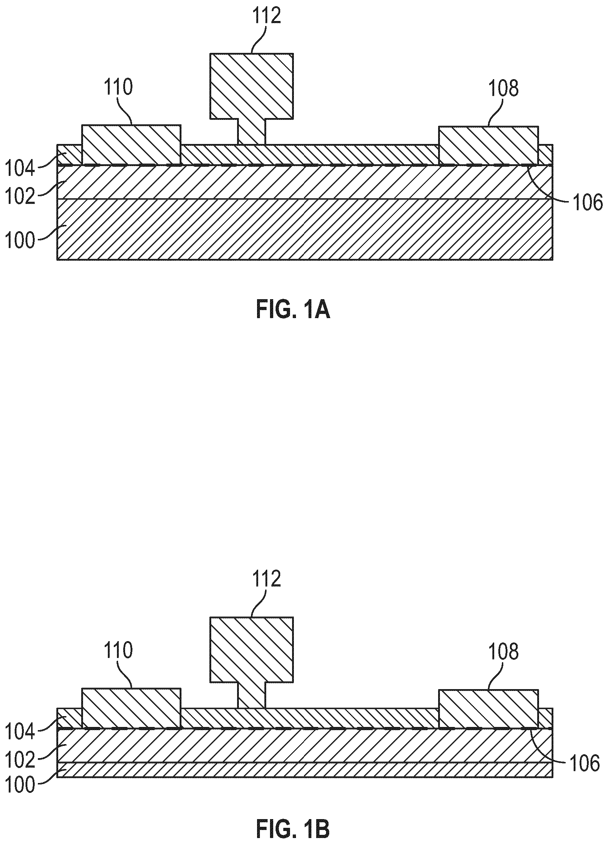

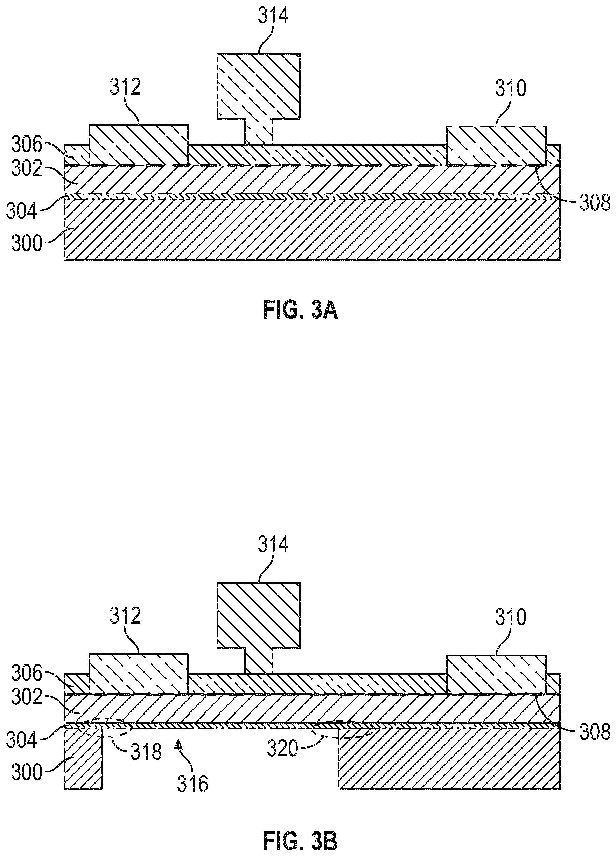

FIG. 1A - FIG. 1D depict an example of a simplified process flow for forming a compound semiconductor heterostructure transistor device, in accordance with this disclosure. FIG. 1A - FIG. 1D depict cross-sectional diagrams at various stages of the process flow. FIG. 1A depicts a substrate 100, such as silicon (Si) or silicon carbide (SiC). A first semiconductor material layer 102 is formed over the substrate 100. For example, a GaN layer may be formed over the substrate 100. In some examples, a nucleation layer, such as aluminum nitride (AlN), may first be formed over the substrate 100 and then the first semiconductor material layer 102 may be epitaxially grown over the nucleation layer. An example of a nucleation layer 304 is shown in FIG. 3A.

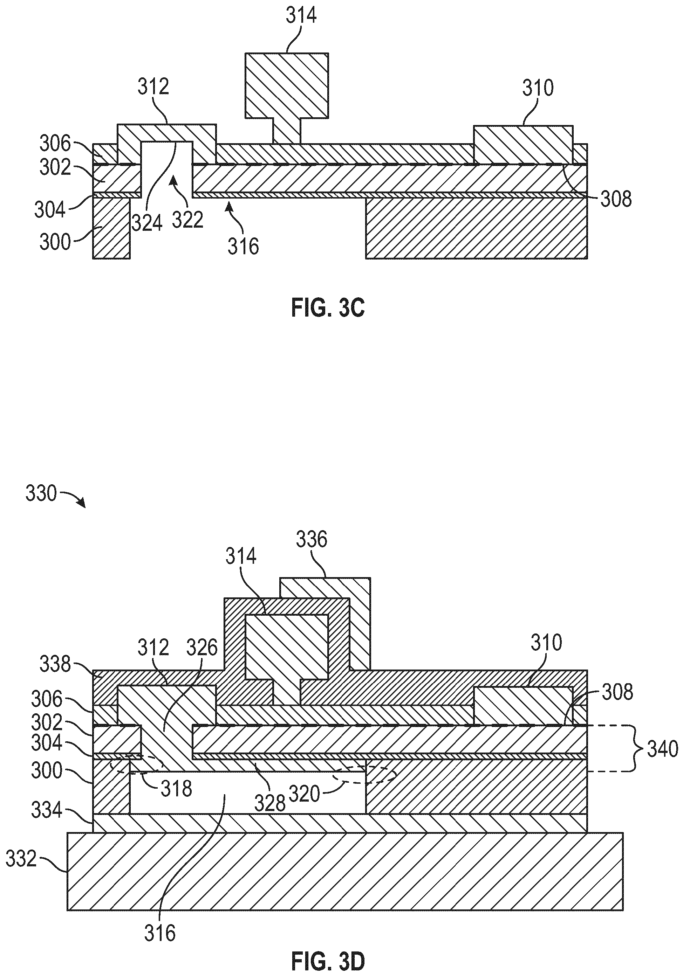

A second semiconductor material layer 104, e.g., aluminum gallium layer (AlGaN), is formed over the first semiconductor material layer 102, thereby forming a compound semiconductor heterostructure having a two-dimensional electron gas (2DEG) channel 106 (shown as a dashed line). The 2DEG channel 106 is more conductive than either the first semiconductor material layer 102 or the second semiconductor material layer 104. In some examples, a passivation layer, such as silicon nitride (SiN) or silicon oxide, may be formed over the second semiconductor material layer 104. An example of a passivation layer 338 is shown in FIG. 3D.

A drain electrode 108 and a source electrode 110 are formed and electrically coupled with the 2DEG channel 106. The gate electrode 112 is formed over the second semiconductor material layer 104.

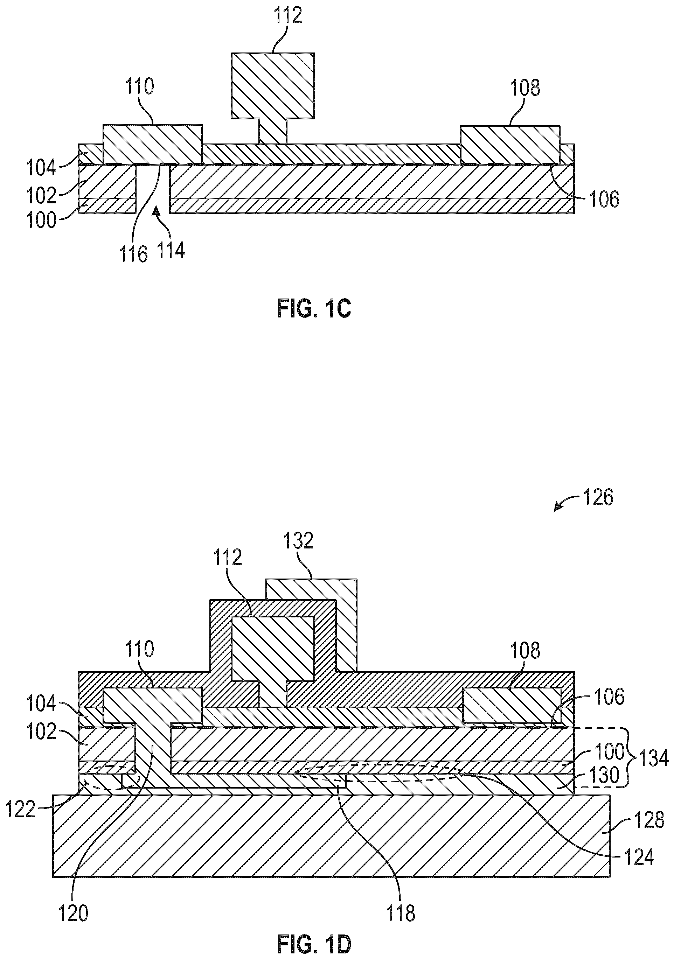

FIG. 1B depicts the substrate 100 thinned to a predetermined thickness to facilitate the placement of a backside field plate in proximity to the two-dimensional electron gas (2DEG) channel 106. The backside field plate is configured to modulate an electric field between a gate electrode and a drain electrode of the transistor device. The present inventors have recognized the desirability of reducing or minimizing a distance 134 (shown in FIG. 1D) between a backside field plate and the two-dimensional electron gas (2DEG) channel 106. To that end, in examples with a thinner first semiconductor material layer 102, e.g., GaN layer, the substrate 100 may be thicker. In some examples, the distance 134 (shown in FIG. 1D) between the backside field plate and the two-dimensional electron gas (2DEG) channel 106 is less than or equal to 500 nm. In some examples, the substrate may be thinned to 100 nanometers (nm) or less. In some examples, the two-dimensional electron gas (2DEG) channel 106 is between 20 nm and 500 nm from the backside field plate 118 shown in FIG. 1D.

FIG. 1C depicts a via 114 formed to the source electrode 110. The via 114 is formed through the thinned substrate 100, the first semiconductor material layer 102, e.g., GaN epi layer, and the second semiconductor material layer 104, to an underside 116 of the source electrode 110.

FIG. 1D depicts a backside field plate 118 formed beneath the thinned substrate 100. A first metal 120 is deposited in the via 114 of FIG. 1C and the backside field plate 118 is formed using a second metal, and the backside field plate 118 is coupled to the source with the first metal 120. In some examples, the first metal and the second metal are the same type of metal. In some examples, the backside field plate 118 is formed from tungsten, aluminum, or copper.

In the example shown in FIG. 1D, the backside field plate 118 is coupled with the first metal 120 and extends laterally from a first region 122 adjacent to the via 114 to a second region 124 between the gate electrode 112 and the drain electrode 108.

In some examples, the substrate 100 of the compound semiconductor heterostructure transistor device 126 of FIG. 1D is bonded to a carrier wafer 128, such as by using a bonding material 130.

In some examples, a backside field plate electrode is electrically coupled with the backside field plate 118. In some such examples, the backside field plate electrode is electrically coupled with a voltage supply, e.g., one that is independent of a gate voltage, a drain voltage, and a source voltage.

In some examples, a topside field plate 132 is formed over the second semiconductor material layer 104 to further assist in controlling electrical fields.

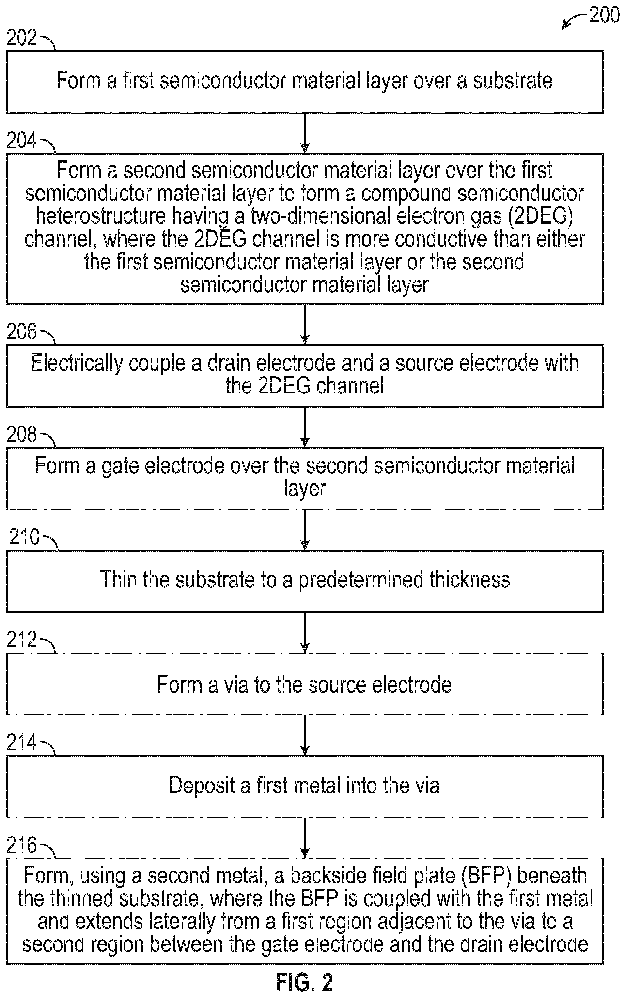

FIG. 2 is a flow diagram depicting an example of a method 200 of forming a compound semiconductor heterostructure transistor device. The method 200 of FIG. 2 relates to the process flow shown in FIG. 1A through FIG. 1D. At block 202, the method 200 includes forming a first semiconductor material layer over a substrate.

At block 204, the method 200 includes forming a second semiconductor material layer over the first semiconductor material layer to form a compound semiconductor heterostructure having a two-dimensional electron gas (2DEG) channel, where the 2DEG channel is more conductive than either the first semiconductor material layer or the second semiconductor material layer.

At block 206, the method 200 includes electrically coupling a drain electrode and a source electrode with the 2DEG channel. At block 208, the method 200 includes forming a gate electrode over the second semiconductor material layer.

At block 210, the method 200 includes thinning the substrate to a predetermined thickness. At block 212, the method 200 includes forming a via to the source electrode.

At block 214, the method 200 includes depositing a first metal into the via. At block 216, the method 200 includes forming, using a second metal, a backside field plate (BFP) beneath the thinned substrate, where the BFP is coupled with the first metal and extends laterally from a first region adjacent to the via to a second region between the gate electrode and the drain electrode.

FIG. 3A - FIG. 3D depict another example of a simplified process flow for forming a compound semiconductor heterostructure transistor device, in accordance with this disclosure. FIG. 3A - FIG. 3D depict cross-sectional diagrams at various stages of the process flow. FIG. 3A depicts a substrate 300, such as silicon (Si) or silicon carbide (SiC). A first semiconductor material layer 302 is formed over the substrate 300. For example, a GaN layer may be formed over the substrate 300. In some examples, a nucleation layer 304, such as aluminum nitride (AlN), may first be formed over the substrate 300 and then the first semiconductor material layer 302 may be epitaxially grown over the nucleation layer 304.

A second semiconductor material layer 306, e.g., aluminum gallium layer (AlGaN), is formed over the first semiconductor material layer 302, thereby forming a compound semiconductor heterostructure having a two-dimensional electron gas (2DEG) channel 308 (shown as a dashed line). The 2DEG channel 308 is more conductive than either the first semiconductor material layer 302 or the second semiconductor material layer 306. In some examples, a passivation layer, such as silicon nitride (SiN) or silicon oxide, may be formed over the second semiconductor material layer 306.

A drain electrode 310 and a source electrode 312 are formed and electrically coupled with the 2DEG channel 308. The gate electrode 314 is formed over the second semiconductor material layer 306.

FIG. 3B depicts a portion of the substrate 300 removed, e.g., via etching, to form a cavity 316. The cavity 316 extends laterally from a first region 318 at least partially underlying the source electrode 312 to a second region 320 between the gate electrode 314 and the drain electrode 310. The formation of the cavity will facilitate the placement of a backside field plate in proximity to the two-dimensional electron gas (2DEG) channel 308.

FIG. 3C depicts a via 322 formed to the source electrode 312. The via 322 is formed, e.g., via etching, through the first semiconductor material layer 302, e.g., GaN epi layer, and the second semiconductor material layer 306 (and the nucleation layer 304, if present) to an underside 324 of the source electrode 312.

FIG. 3D depicts a first metal 326 deposited in the via 322 of FIG. 3C. A backside field plate 328 is formed using a second metal and coupled with the first metal 326. The backside field plate is configured to modulate an electric field between the gate electrode 314 and the drain electrode 310 of the compound semiconductor heterostructure transistor device 330. In some examples, the first metal and the second metal are the same type of metal. In some examples, the backside field plate 328 is formed from tungsten, aluminum, or copper.

In the example shown in FIG. 3D, the backside field plate 328 is coupled with the first metal 326 and extends laterally from the first region 318 adjacent to the via 322 to the second region 320 between the gate electrode 314 and the drain electrode 310.

As mentioned above, the present inventors have recognized the desirability of reducing or minimizing a distance 340 between the backside field plate 328 and the two-dimensional electron gas (2DEG) channel 308. In some examples, the distance 340 between the backside field plate 328 and the two-dimensional electron gas (2DEG) channel 308 is less than or equal to 500 nm.

In some examples, the substrate 300 of the compound semiconductor heterostructure transistor device 330 of FIG. 3D is bonded to a carrier wafer 332, such as by using a bonding material 334.

In some examples, a backside field plate electrode is electrically coupled with the backside field plate 328. In some such examples, the backside field plate electrode is electrically coupled with a voltage supply, e.g., one that is independent of a gate voltage, a drain voltage, and a source voltage.

In some examples, a topside field plate 336 is formed over the second semiconductor material layer 306 (and, if present, over a passivation layer 338) to further assist in controlling electrical fields.

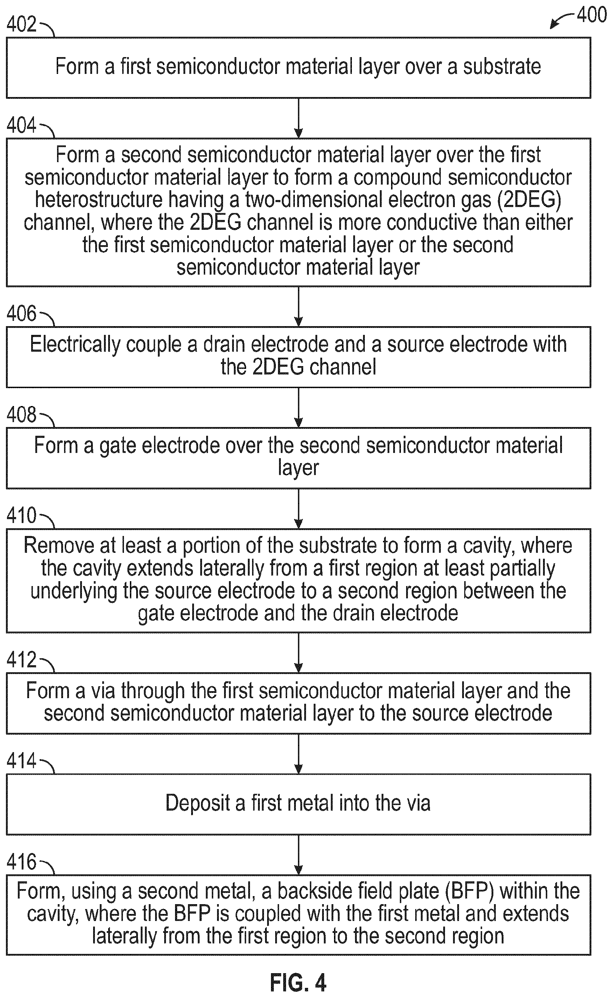

FIG. 4 is a flow diagram depicting another example of a method 400 of forming a compound semiconductor heterostructure transistor device. The method 400 of FIG. 4 relates to the process flow shown in FIG. 3A through FIG. 3D.

At block 402, the method 400 includes forming a first semiconductor material layer over a substrate. At block 404, the method 400 includes forming a second semiconductor material layer over the first semiconductor material layer to form a compound semiconductor heterostructure having a two-dimensional electron gas (2DEG) channel, where the 2DEG channel is more conductive than either the first semiconductor material layer or the second semiconductor material layer.

At block 406, the method 400 includes electrically coupling a drain electrode and a source electrode with the 2DEG channel. At block 408, the method 400 includes forming a gate electrode over the second semiconductor material layer.

At block 410, the method 400 includes removing at least a portion of the substrate to form a cavity, where the cavity extends laterally from a first region at least partially underlying the source electrode to a second region between the gate electrode and the drain electrode. At block 412, the method 400 includes forming a via through the first semiconductor material layer and the second semiconductor material layer to the source electrode. At block 414, the method 400 includes depositing a first metal into the via. At block 416, the method 400 includes forming, using a second metal, a backside field plate (BFP) within the cavity, where the BFP is coupled with the first metal and extends laterally from the first region to the second region.

### Various Notes

Each of the non-limiting claims or examples described herein may stand on its own, or may be combined in various permutations or combinations with one or more of the other examples.

The above-detailed description includes references to the accompanying drawings, which form a part of the detailed description. The drawings show, by way of illustration, specific embodiments in which the invention may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more claims thereof), either with respect to a particular example (or one or more claims thereof), or with respect to other examples (or one or more claims thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or non-volatile tangible computer-readable media, such as during execution or at other times. Examples of these tangible computer-readable media may include, but are not limited to, hard disks, removable magnetic disks, removable optical disks (e.g., compact discs and digital video discs), magnetic cassettes, memory cards or sticks, random access memories (RAMs), read only memories (ROMs), and the like.

The above description is intended to be illustrative, and not restrictive. For example, the above-described examples (or one or more claims thereof) may be used in combination with each other. Other embodiments may be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments may be combined with each other in various combinations or permutations. The scope of the invention should be determined with reference to the appended claims, along with the full scope of equivalents to which such claims are entitled.

### Numbered aspects

By way of non-limiting example, some aspects of the disclosure are set out in the following numbered clauses.

Numbered Clause 1. A method of forming a compound semiconductor heterostructure transistor device, the method comprising:
forming a first semiconductor material layer over a substrate;
forming a second semiconductor material layer over the first semiconductor material layer to form a compound semiconductor heterostructure having a two-dimensional electron gas (2DEG) channel, wherein the 2DEG channel is more conductive than either the first semiconductor material layer or the second semiconductor material layer;
electrically coupling a drain electrode and a source electrode with the 2DEG channel;
forming a gate electrode over the second semiconductor material layer;
thinning the substrate to a predetermined thickness;
forming a via to the source electrode;
depositing a first metal into the via; and
forming, using a second metal, a backside field plate (BFP) beneath the thinned substrate, wherein the BFP is coupled with the first metal and extends laterally from a first region adjacent to the via to a second region between the gate electrode and the drain electrode.

Numbered Clause 2. The method of Numbered Clause 1, comprising:
bonding a carrier wafer to the substrate.

Numbered Clause 3. The method of Numbered Clause 1 or 2, comprising:
forming a field plate over the second semiconductor material layer.

Numbered Clause 4. The method of any preceding claim, wherein thinning the substrate to the predetermined thickness includes:
thinning the substrate to 100 nanometers or less.

Numbered Clause 5. The method of any preceding Numbered Clause, wherein a distance between the 2DEG channel and the backside field plate is 500 nanometers or less.

Numbered Clause 6. The method of any preceding Numbered Clause, wherein the first metal and the second metal are the same type of metal.

Numbered Clause 7. The method of any preceding Numbered Clause, wherein forming the first semiconductor material layer over the substrate includes:
forming a gallium nitride (GaN) layer over the substrate.

Numbered Clause 8. The method of Numbered Clause 7, wherein forming the second semiconductor material layer over the first semiconductor material layer includes:
forming an aluminum gallium layer (AlGaN) over the GaN layer.

Numbered Clause 9. A method of forming a compound semiconductor heterostructure transistor device, the method comprising:
forming a first semiconductor material layer over a substrate;
forming a second semiconductor material layer over the first semiconductor material layer to form a compound semiconductor heterostructure having a two-dimensional electron gas (2DEG) channel, wherein the 2DEG channel is more conductive than either the first semiconductor material layer or the second semiconductor material layer;
electrically coupling a drain electrode and a source electrode with the 2DEG channel;
forming a gate electrode over the second semiconductor material layer;
removing at least a portion of the substrate to form a cavity, wherein the cavity extends laterally from a first region at least partially underlying the source electrode to a second region between the gate electrode and the drain electrode;
forming a via through the first semiconductor material layer and the second semiconductor material layer to the source electrode;
depositing a first metal into the via; and
forming, using a second metal, a backside field plate (BFP) within the cavity, wherein the BFP is coupled with the first metal and extends laterally from the first region to the second region.

Numbered Clause 10. The method of Numbered Clause 9, comprising:
bonding a carrier wafer to the substrate.

Numbered Clause 11. The method of Numbered Clause 9 or 10, comprising:
forming a field plate over the second semiconductor material layer.

Numbered Clause 12. The method of any of Numbered Clauses 9 to 11, wherein a distance between the 2DEG channel and the backside field plate is 500 nanometers or less.

Numbered Clause 13. The method of any of Numbered Clauses 9 to 12, wherein the first metal and the second metal are the same type of metal.

Numbered Clause 14. The method of any of Numbered Clauses 9 to 13, wherein forming the first semiconductor material layer over the substrate includes:
forming a gallium nitride (GaN) layer over the substrate.

Numbered Clause 15. The method of Numbered Clause 14, wherein forming the second semiconductor material layer over the first semiconductor material layer includes:
forming an aluminum gallium layer (AlGaN) over the GaN layer.

Numbered Clause 16. A compound semiconductor heterostructure transistor device comprising:
a substrate;
a first semiconductor material layer formed over the substrate;
a second semiconductor material layer formed over the first semiconductor material layer to form a compound semiconductor heterostructure having a two-dimensional electron gas (2DEG) channel, wherein the 2DEG channel is more conductive than either the first semiconductor material layer or the second semiconductor material layer;
a drain electrode electrically coupled with the 2DEG channel;
a source electrode electrically coupled with the 2DEG channel;
a gate electrode formed over the second semiconductor material layer; and
a metal backside field plate formed within a cavity of the substrate, wherein the backside field plate extends laterally from a first region at least partially underlying the source electrode to a second region between the gate electrode and the drain electrode, wherein the backside field plate is electrically coupled to the source electrode.

Numbered Clause 17. The compound semiconductor heterostructure transistor device of Numbered Clause 16, wherein a distance between the 2DEG channel and the backside field plate is 500 nanometers or less.

Numbered Clause 18. The compound semiconductor heterostructure transistor device of Numbered Clause 16 or 17, comprising:
a carrier wafer bonded to the substrate.

Numbered Clause 19. The compound semiconductor heterostructure transistor device of any of Numbered Clauses 16 to 18, comprising:
a field plate formed over the second semiconductor material layer.

Numbered Clause 20. The compound semiconductor heterostructure transistor device of any of Numbered Clauses 16 to 19, wherein the first semiconductor material layer includes gallium nitride (GaN); and
wherein the second semiconductor material layer includes aluminum gallium (AlGaN).

## Claims

1. A method of forming a compound semiconductor heterostructure transistor device, the method comprising:
forming a first semiconductor material layer over a substrate;
forming a second semiconductor material layer over the first semiconductor material layer to form a compound semiconductor heterostructure having a two-dimensional electron gas (2DEG) channel, wherein the 2DEG channel is more conductive than either the first semiconductor material layer or the second semiconductor material layer;
electrically coupling a drain electrode and a source electrode with the 2DEG channel;
forming a gate electrode over the second semiconductor material layer;
thinning the substrate to a predetermined thickness;
forming a via to the source electrode;
depositing a first metal into the via; and
forming, using a second metal, a backside field plate (BFP) beneath the thinned substrate, wherein the BFP is coupled with the first metal and extends laterally from a first region adjacent to the via to a second region between the gate electrode and the drain electrode.

2. The method of claim 1, further comprising:
bonding a carrier wafer to the substrate
and/or
forming a field plate over the second semiconductor material layer.

3. The method of any preceding claim, wherein thinning the substrate to the predetermined thickness includes:
thinning the substrate to 100 nanometers or less.

4. The method of any preceding claim, wherein a distance between the 2DEG channel and the backside field plate is 500 nanometers or less.

5. The method of any preceding claim, wherein the first metal and the second metal are the same type of metal.

6. The method of any preceding claim, wherein forming the first semiconductor material layer over the substrate includes:
forming a gallium nitride (GaN) layer over the substrate,
preferably wherein forming the second semiconductor material layer over the first semiconductor material layer includes:
forming an aluminum gallium layer (AlGaN) over the GaN layer.

7. A method of forming a compound semiconductor heterostructure transistor device, the method comprising:
forming a first semiconductor material layer over a substrate;
forming a second semiconductor material layer over the first semiconductor material layer to form a compound semiconductor heterostructure having a two-dimensional electron gas (2DEG) channel, wherein the 2DEG channel is more conductive than either the first semiconductor material layer or the second semiconductor material layer;
electrically coupling a drain electrode and a source electrode with the 2DEG channel;
forming a gate electrode over the second semiconductor material layer;
removing at least a portion of the substrate to form a cavity, wherein the cavity extends laterally from a first region at least partially underlying the source electrode to a second region between the gate electrode and the drain electrode;
forming a via through the first semiconductor material layer and the second semiconductor material layer to the source electrode;
depositing a first metal into the via; and
forming, using a second metal, a backside field plate (BFP) within the cavity, wherein the BFP is coupled with the first metal and extends laterally from the first region to the second region.

8. The method of claim 7, further comprising:
bonding a carrier wafer to the substrate
and/or
forming a field plate over the second semiconductor material layer.

9. The method of claim 7 or 8, wherein a distance between the 2DEG channel and the backside field plate is 500 nanometers or less.

10. The method of any of claims 7 to 9, wherein the first metal and the second metal are the same type of metal.

11. The method of any of claims 7 to 10, wherein forming the first semiconductor material layer over the substrate includes:
forming a gallium nitride (GaN) layer over the substrate,
preferably wherein forming the second semiconductor material layer over the first semiconductor material layer includes:
forming an aluminum gallium layer (AlGaN) over the GaN layer.

12. A compound semiconductor heterostructure transistor device comprising:
a substrate;
a first semiconductor material layer formed over the substrate;
a second semiconductor material layer formed over the first semiconductor material layer to form a compound semiconductor heterostructure having a two-dimensional electron gas (2DEG) channel, wherein the 2DEG channel is more conductive than either the first semiconductor material layer or the second semiconductor material layer;
a drain electrode electrically coupled with the 2DEG channel;
a source electrode electrically coupled with the 2DEG channel;
a gate electrode formed over the second semiconductor material layer; and
a metal backside field plate formed within a cavity of the substrate, wherein the backside field plate extends laterally from a first region at least partially underlying the source electrode to a second region between the gate electrode and the drain electrode, wherein the backside field plate is electrically coupled to the source electrode.

13. The compound semiconductor heterostructure transistor device of claim 12, wherein a distance between the 2DEG channel and the backside field plate is 500 nanometers or less.

14. The compound semiconductor heterostructure transistor device of claim 12 or 13, further comprising:
a carrier wafer bonded to the substrate
and/or
a field plate formed over the second semiconductor material layer.

15. The compound semiconductor heterostructure transistor device of any of claims 12 to 14, wherein the first semiconductor material layer includes gallium nitride (GaN); and
wherein the second semiconductor material layer includes aluminum gallium (AlGaN).
